# EUROPÄISCHE PATENTSCHRIFT

(11) **EP 0 809 295 B1**
(45) Veröffentlichungstag und Bekanntmachung des Hinweises auf die Patenterteilung: **02.04.2003**
(21) Anmeldenummer: 97108031.2
(22) Anmeldetag: 16.05.1997
(51) Int. Cl.: H01L 27/02

(54) **MOSFET mit Temperaturschutz**
Mosfet with temperature protection
Mosfet avec protection en température

(30) Priorität: 21.05.1996 DE 19620429
(43) Veröffentlichungstag der Anmeldung: 26.11.1997
(73) Patentinhaber: Infineon Technologies AG, 81669 München (DE)
(72) Erfinder: Tihanyi, Jenö Dr. Ing., 85551 Kirchheim (DE)
(74) Vertreter: Patentanwälte Westphal, Mussgnug & Partner

(56) Entgegenhaltungen:
- EP-A- 0 632 501
- DE-A- 3 730 649
- DE-A- 3 936 544
- DE-A- 4 120 394
- DE-A- 4 122 653
- GB-A- 2 291 742
- US-A- 4 947 234
- PATENT ABSTRACTS OF JAPAN vol. 018, no. 629 (E-1637), 30. November 1994 (1994-11-30) -& JP 06 244414 A (HITACHI LTD), 2. September 1994 (1994-09-02)
- "POWER SWITCH GETS SMART WITH PROTECTION" ELECTRONIC ENGINEERING,GB,MORGAN-GRAMPIAN LTD. LONDON, Bd. 65, Nr. 801, 1. September 1993 (1993-09-01), Seite 7 XP000396401 ISSN: 0013-4902
- KAIFLER E ET AL: "BASIC CIRCUITS USING SIPMOS FET DRIVERS NEW OPTOCOUPLERS OPEN UP NEW CIRCUIT POSSIBILITIES" COMPONENTS,DE,SIEMENS AKTIENGESELLSCHAFT. MUNCHEN, Bd. 24, Nr. 1, 1. Februar 1989 (1989-02-01), Seiten 18-23, XP000096685 ISSN: 0945-1137

## Beschreibung

Die vorliegende Erfindung betrifft einen MOSFET mit Temperaturschutz mit einem zwischen Gateanschluß und Sourceanschluß des MOSFET geschalteten Schaltelement.

Ein MOSFET mit Temperaturschutz ist z. B. aus der DE 43 05 038 bekannt. Das dort zwischen Gate- und Sourceelektroden geschaltete Schaltelement schaltet den MOSFET bei Erreichen einer kritischen Temperatur ab. Hierzu wird ein temperaturabhängiges Signal erzeugt, mit dem das Schaltelement angesteuert wird, welches bei Erreichen einer Temperatur, die niedriger als die kritische Temperatur ist, Gate und Source des MOSFET über die Laststrecke des Schaltelementes kurzschließt. Dadurch wird die Gate-Source-Spannung des MOSFET und somit der durch ihn fließende Strom verringert. Der Temperaturanstieg wird so verlangsamt.

Aus der DE 39 36 544 A1 ist eine Schaltungsanordnung (entsprechend der Preambel des Anspruchs 1) zum Schutz eines Leistungs-MOSFET bei einem Kurzschluss einer zu dem Leistungs-MOSFET in Reihe geschalteten Last bekannt. Zum Erfassen des Kurzschlusses wird die Drain-Source-Spannung des MOSFET mit einer Referenzspannung verglichen. Übersteigt diese Drain-Source-Spannung den durch die Referenzspannung gegebenen Wert, so wird ein zwischen dem Gate-Anschluss und dem Source-Anschluss des MOSFET liegender Schalter leitend angesteuert, der die Gate-Source-Kapazität entlädt. Der Schalter steuert seinerseits einen zwischen einem Treiber und den Gate-Anschluss geschalteten steuerbaren Widerstand so an, dass der Widerstandswert steigt, um den zusätzlichen Ladestrom der Gate-Source-Kapazität zu verringern. Diese Maßnahmen bewirken ein sanftes Abschalten des MOSFET.

Aufgabe der vorliegenden Erfindung ist es, eine einfachere Lösung für eine Temperaturschutzschaltung anzugeben.

Diese Aufgabe wird durch eine Schaltungsanordnung gemäß den Merkmalen des Anspruchs 1 gelöst. Weiterbildungen sind Gegenstand der Unteransprüche.

Vorteil der vorliegenden Erfindung ist es, dass lediglich eine Diode als Temperaturerfassungselement verwendet wird. Der Strom durch diese Diode, welcher temperaturabhängig ist, wird dem Gate eines Verarmungs-MOSFET zugeführt, der durch eine Ladungspumpenschaltung im eingeschalteten Zustand des Hauptschalters gesperrt ist. Die Diode ist mitintegrierbar. Die Funktion der Schaltungsanordnung wird gegenüber dem Stand der Technik vorteilhafterweise unabhängig von der Drain-Source-Spannung des MOSFET.

Die Stromversorgungsschaltung zum Vorspannen des Depletion-MOSFET ist einer besonders günstigen Ausführungsform als Oszillator ausgebildet. In einer zweckmäßigen Ausführung ist dieser Oszillator ein Ringoszillator.

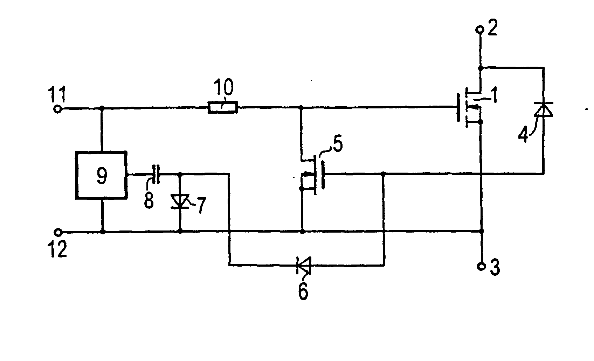

Die Erfindung wird nachfolgend anhand von einer einzigen Figur näher erläutert.

In der Figur ist mit 1 der Leistungs-MOSFET bezeichnet, dessen Drainanschluß mit einer Klemme 2 verbunden ist und dessen Sourceanschluß mit einer Klemme 3 verschaltet ist. Der Gateanschluß des Leistungs-MOSFET 1 ist über einen Widerstand 10 mit der Klemme 11 verschaltet. Zwischen dem Gateanschluß des Leistungs-MOSFET 1 und dessen Sourceanschluß ist die Laststrecke eines Depletion-MOSFET 5 geschaltet, dessen Gate über eine Diode 4 mit dem Drainanschluß des Leistungs-MOSFET 1 verbunden ist. Des weiteren ist der Gateanschluß des Depletion-MOSFET 5 über Reihenschaltung zweier Dioden 6 und 7 mit dem Sourceanschluß des Leistungs-MOSFET 1 verschaltet. Eine weitere Eingangsklemme 12 ist vorgesehen, die mit dem Sourceanschluß des Leistungs-MOSFET 1 verschaltet ist. Zwischen den Eingangsklemmen 11 und 12 ist ein Oszillator 9 geschaltet, dessen Ausgang über einen Kondensator 8 mit dem Knotenpunkt der Reihenschaltung der beiden Dioden 6 und 7 verbunden ist. Der Oszillator läuft, wenn die Eingangsspannung positiv ist, d.h. eingeschaltet werden soll.

Die Diode 4 ist in den Leistungs-MOSFET 1 mit integriert und in Sperrichtung geschaltet. Diese Diode 4 wird zur Stromquelle, wenn die Chiptemperatur steigt und sie zieht das Gate des Depletion-MOSFET 5 gegen den Ladungspumpenstrom in positive Richtung, wenn sie sich in einem sogenannten heißen Zustand befindet.

Liegt zwischen der Klemme 11 und 12 kein Signal an, d. h. daß der Leistungs-MOSFET 1 sperren soll, so gelangt kein Signal zum Gate des Leistungs-MOSFET 1 und dieser sperrt. Liegt dagegen ein Signal an der Klemme 11 an, so gelangt dieses über den Widerstand 10 zum Gate des Leistungs-MOSFET 1 und dieser leitet. Gleichzeitig wird der Oszillator 9 aktiviert und dieser erzeugt über den Ladegleichrichter, bestehend aus dem Kondensator 8 und den beiden Dioden 6 und 7, ein Signal, welches den Transistor 5 ständig gesperrt hält. Steigt dagegen die Temperatur im Leistungs-MOSFET 1 an, so fließt ein Strom über die Diode 4 und dieser Strom kompensiert den Strom, der durch den Oszillator 9 mit nachgeschaltetem Ladegleichrichter erzeugt wird. Dadurch wird der Depletion-Transistor 5 leitend geschaltet und dessen Laststrecke reduziert die Gatespannung des Leistungs-MOSFET 1.

Von besonderem Vorteil ist, daß eine derartige Schaltungsanordnung bei jeder Drain-Source-Spannung des Leistungs-MOSFET 1 funktioniert. Damit ist die erfindungsgemäße Schaltungsanordnung sowohl bei einer 1-Chip-Version wie auch bei einer Mehr-Chip-Version, wie z. B. einer 2-Chip-Version, realisierbar. Des weiteren kann eine derartige Schaltung mit gängigen Strombegrenzungen und Überspannungsschutzschaltungen, wie z. B. Aktivzenerdioden, kombiniert werden.

Die erfindungsgemäße Temperaturschutzschaltung kann auch mit einer zusätzlich feineren, z. B. einem latchenden Temperaturschutz, realisiert werden.

Der Oszillator 9 sollte zweckmäßigerweise einen geringen Stromverbrauch haben, welcher im Bereich < 100 µA liegen kann. Dadurch wird auch der Ladestrom über die Diode 6 ungefähr im Microamperebereich liegen. Die Dioden 6 und 7 können zweckmäßigerweise als MOS-Dioden ausgeführt werden. Als Realisierungsmöglichkeit für den Oszillator 9 kommt z. B. ein einfacher Ringoszillator mit Buffer-Ausgang in Frage.

## Patentansprüche

1. Schaltungsanordnung, die einen MOSFET (1) mit Temperaturschutz sowie einen Depletion-MOSFET (5) aufweist, wobei eine Laststrecke des Depletion-MOSFET (5) zwischen Gateanschluß und Sourceanschluß des MOSFET (1) geschaltet ist, und wobei ein Gateanschluß des Depletion-MOSFET (5) über eine Diode (4) mit dem Drain-Anschluß des MOSFET (1) verbunden ist,
**dadurch gekennzeichnet,**
**daß** der Gateanschluß des Depletion-MOSFET (5) an eine Ladungspumpenschaltung (6, 7, 8, 9) angeschlossen ist, wobei der Depletion-MOSFET (5) über die Ladungspumpenschaltung (6, ...9) in Sperrrichtung angesteuert ist, wenn der MOSFET (1) eingeschaltet ist.

2. Schaltungsanordnung nach Anspruch 1,
**dadurch gekennzeichnet,**
**daß** die Diode (4) im Chip mitintegriert ist, wobei bei einer Erhöhung der Chiptemperatur der Sperrstrom der Diode (4) den Depletion-MOSFET (5) gegen den Ladungspumpenstrom in den leitenden Zustand steuert.

3. Schaltungsanordnung nach Ansprüche 1 oder 2,
**dadurch gekennzeichnet,**
**daß** die Ladungspumpenschaltung (6, 7, 8, 9) aus einem Oszillator (9) besteht, dessen Ausgang über einen Kondensator (8) mit dem Knotenpunkt einer Reihenschaltung aus zwei Dioden (6, 7) verbunden ist, wobei die Reihenschaltung aus zwei Dioden (6, 7) zwischen Gateanschluß und Sourceanschluß des Depletion-MOSFET (5) geschaltet ist.

4. Schaltungsanordnung nach Anspruch 3,
**dadurch gekennzeichnet,**
**daß** der Oszillator (9) ein Ringoszillator ist.

5. Schaltungsanordnung nach einem der Ansprüche 2 bis 4,
**dadurch gekennzeichnet,**
**daß** der MOSFET (1) und die Diode (4) in einem Chip integriert sind und die Ladungspumpenschaltung (6, ....9) in einem zweiten Chip integriert ist.

## Claims

1. Circuitry comprising a MOSFET (1) having temperature protection and also a depletion MOSFET (5), wherein a load path of the depletion MOSFET (5) is connected between gate terminal and source terminal of the MOSFET (1), and wherein a gate terminal of the depletion MOSFET (5) is connected via a diode (4) to the drain terminal of the MOSFET (1),
**characterised in that** the gate terminal of the depletion MOSFET (5) is connected to a charge pump circuit MOSFET (5) is connected to a charge pump circuit (6, 7, 8, 9), wherein the depletion MOSFET (5) is actuated via the charge pump circuit (6, ... 9) in the reverse direction when the MOSFET (1) is switched on.

2. Circuitry according to Claim 1,
**characterised in that** the diode (4) is also integrated in the chip, with the reverse current of the diode (4) controlling the depletion MOSFET (5) against the charging pump current into the conductive state when the chip temperature is increased.

3. Circuitry according to Claims 1 or 2,
**characterised in that** the charge pump circuit (6, 7, 8, 9) consists of an oscillator (9), the output of which is connected via a capacitor (8) to the node of a series circuit consisting of two diodes (6, 7), the series circuit consisting of two diodes (6, 7) being connected between gate terminal and source terminal of the depletion MOSFET (5).

4. Circuitry according to Claim 3,
**characterised in that** the oscillator (9) is a ring oscillator.

5. Circuitry according to one of the Claims 2 to 4,
**characterised in that** the MOSFET (1) and the diode (4) are integrated in a chip and the charge pump circuit (6, ... 9) is integrated in a second chip.

## Revendications

1. Circuit comportant un MOSFET(1) avec une protection thermique ainsi qu'un MOSFET à appauvrissement (5),
le chemin de charge du MOSFET à appauvrissement (5) étant branché entre la porte et la source du MOSFET (1), et la porte du MOSFET à appauvrissement (5) étant reliée par une diode (4) au drain du MOSFET (1),
**caractérisé en ce que**
le branchement de la porte du MOSFET à appauvrissement (5) est relié à une charge de pompage (6, 7, 8, 9) ;
le MOSFET à appauvrissement (5) étant relié par le circuit de charge de pompage (6, 7, 8, 9) commandé dans le sens du blocage lorsque le MOSFET (1) est mis en oeuvre.

2. Circuit selon la revendication 1,
**caractérisé en ce que**
la diode (4) est intégrée dans une puce et en cas d'augmentation de la température de la puce, le courant de blocage de la diode (4) commande le MOSFET à appauvrissement (5) contre le courant de la charge de pompage à l'état conducteur.

3. Circuit selon la revendication 1 ou 2,
**caractérisé en ce que**
le circuit de charge de pompage (6, 7, 8, 9) est formé d'un oscillateur (9) dont la sortie est reliée par un condensateur (8) au noeud d'un montage en série formé de deux diodes (6, 7),
le montage en série de deux diodes (6, 7) étant branché entre la porte et la source du MOSFET à appauvrissement (5).

4. Circuit selon la revendication 3,
**caractérisé en ce que**
l'oscillateur (9) est un oscillateur en anneau.

5. Circuit selon l'une des revendications 2 à 4,
**caractérisé en ce que**
le MOSFET (1) et la diode (4) sont intégrés dans une puce et le circuit de charge de pompage (6 ... 9) est intégré dans une seconde puce.
